# EUROPEAN PATENT APPLICATION

(11) **EP 1 313 356 A1**
(43) Date of publication of application: **21.05.2003**
(21) Application number: 02025714.3
(22) Date of filing: 15.11.2002
(51) Int. Cl.: H05K 1/11

(54) **Low impedance/high density connectivity of surface mount components on a printed wiring board**

(30) Priority: 15.11.2001 US 902
(71) Applicant: Xerox Corporation, Rochester, New York 14644 (US)
(72) Inventor: Dances, Robert J., Torrance, California 90503-6581 (US)
(74) Representative: Grünecker, Kinkeldey, Stockmair & Schwanhäusser Anwaltssozietät

(57) **Abstract**

A surface mounted component (110) and a via (118,120) share the same pad (112,114) on the surface (116) of a multilayered printed wiring board (100) to increase the density of surface mounted components on the surface and to reduce the impedance between the surface mounted component (110) and the via (118,120).

## Description

### BACKGROUND OF THE INVENTION

The present invention relates to surface mounted components on a printed wiring board (PWB) and, more particularly, to increasing the density of surface mounted components and decreasing the impedance of traces on a printed wiring board.

A printed wiring board is a flat plate or base of insulating material containing a pattern of conducting material. The patterned conducting material form traces which electrically connect electronic components mounted on the surface of the printed wiring board to form circuits.

The patterned conducting material is commonly copper which has been coated with solder or plated with tin or tin-lead alloy. The usual insulating material is epoxy laminate. But there are many other kinds of materials used in more exotic technologies. Printed wiring boards are also called printed circuit boards.

The patterned conducting material in addition to forming connective traces also forms pads, conductive areas on the surface of the printing wiring board. Pads are provided on the board so that connection can be made to the surface mounted components. These pads are commonly coated with solder and connections are made by reflow of the solder. When the component pad or lead is in contact with the pad on the printed wiring board, sufficient heat is applied to melt the solder on the pad so that it reflows into a connection with the component. The component may be connected by means of a lead frame on a package, individual wiring, or by placement of a leadless chip carrier with its pads directly in contact with the pads on the printed wiring board.

The surface mounted components are any of the basic electronic parts used in forming a circuit such as resistors, capacitors, DIP, integrated circuits and the like.

Single layer printed wiring boards have all the conductors, the traces, pads and surface mounted components on one side of the board. Single layer boards suffer the well-known problem of crossing traces and a limited space for components. In order to overcome the crossover and density problems, multi-layer printed wiring boards are provided.

A multilayer printed wiring board is a printed wiring board comprising a plurality of conductive wiring layers with interim insulating layers. By installing pads for connection on the wiring layers, forming a through-hole penetrating all of the board's wiring and insulating layers and coating this through-hole with conductive material, e.g., copper, a method for electrically connecting separate conductive wiring layers using the through-hole is possible. A through-hole is thus understood to pass through the board's entire thickness.

In addition, a conductive via can also be used as a means for electrically connecting selected adjacent wiring layers. A via is typically a small hole provided in the insulating layer through a pad, having the interior hole surface plated with conductive material, and which serves to electrically connect upper and lower conductive layers on opposite sides of the insulating layer. In multilayer boards, the vias can connect to inside conductors layers as well as either or both outside layers. A via is thus understood to comprise an internally positioned conductive hole within the final printed wiring board structure, as opposed to a through-hole which passes entirely through the printed wiring board.

Traces on the surface of the layers of the printed wiring board allow signals to travel from surface mounted component to surface mounted component. Vias between the layers of the printed wiring board allow signals to travel from layer to layer in a multilayer board.

Multilayer printed wiring boards are commonly provided with inner ground and power layers. These inner layers are frequently solid sheets of conductive copper only interrupted by clearance holes (the perforations required for electrically isolating the through hole pattern of the printed wiring board) and vias. These ground and power layers provide power voltage and current and ground connections for the surface mounted components of the multilayer printed circuit through the vias. A second function of the ground and power layers is to provide electromagnetic shielding for the multilayer printed wiring board and reduce the electromagnetic and radio frequency interference.

Conventional printed wiring boards are manufactured by joining an epoxy laminate and a copper laminate with heat and pressure. The epoxy laminate is much thicker than the copper laminate and it provides mechanical support for the printed wiring board. Application of heat and pressure causes the epoxy to soften and bond to the copper laminate. The copper laminate surface is treated either chemically, or electrochemically with dendritic treatment, which produces a jagged surface on a microscopic scale, which promotes adhesion to the epoxy laminate.

Photo-resist is then applied on the copper laminate surface. Liquid photo-resist application has recently been replaced by "dry" photo-resist methods. In the dry photo-resist technique, a photo-resist film is laminated on the copper laminate surface, also by application of heat and pressure.

The conductor pattern for the traces and pads for the circuitry of the printed wiring board is then "exposed" on the photo-resist. The exposed board is "developed" in an appropriate chemical solution that dissolves the photo-resist, consequently exposing the copper laminate surface along the areas which are to be etched.

In the copper etching operation, the developed board is passed through a chemical spray chamber, where jets spray chemicals which dissolve copper. The photo-resist and the copper etching solution have been chosen so that the sprayed chemicals only dissolves the copper and not the photo-resist. At the conclusion of the copper etching p rocess, a w ell d efined c onductor p attem of traces and p ads w ith a overlay of photo-resist is left on the epoxy laminate substrate.

The photo-resist overlay is then etched away by another chemical solution which etches only the photo-resist and not the copper.

Multilayer printed wiring boards may contain several layers of alternate copper conductor laminates and epoxy laminates.

Interconnection between the traces on different layers is accomplished by drilling through holes at the appropriate layers and depositing copper in the holes which adheres in thin films to the sidewalls of the through holes to form conductive vias. The vias will also have connective conductive pads on the surface of the printed wiring board. The choice of conductive lining material (such as tungsten, copper, and gold) for the vias depends upon the nature of the board-layer substrate used.

The necessary surface mount components are then mounted to the appropriate pre-determined points on the conductive trace and pad pattern on the surface of the printed wiring board.

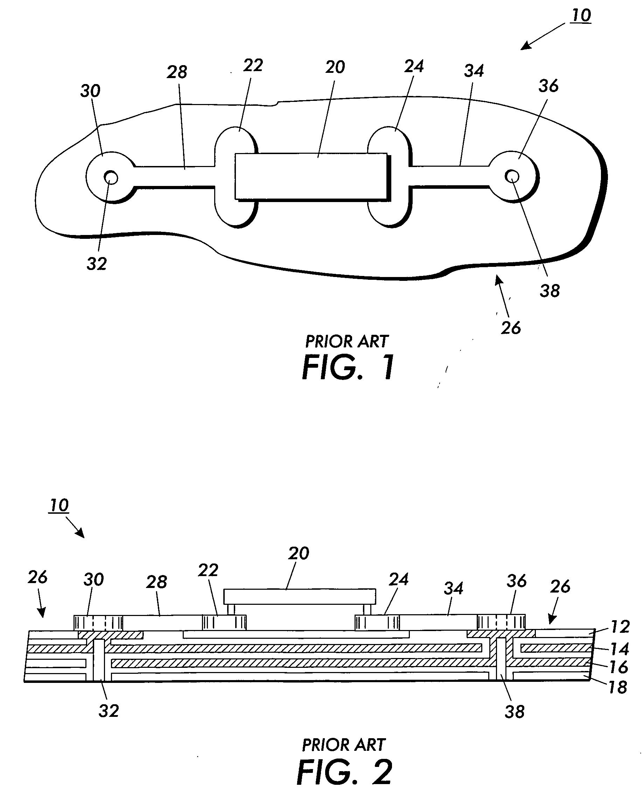

As shown in Figures 1 and 2, the multilayered prior art printed wiring board 10 has, in succession, a first outer layer 12, an inner power layer 14, an inner ground layer 16 and a second outer layer 18.

A surface mounted component 20 is mounted on a first pad 22 and a second pad 24 on the surface 26 of the first outer layer 12. The first pad 22 is sconnected through a trace 28 to a first via pad 30 on the surface 26 of the first outer layer 12.

The first via 32 extends from the first via pad 30 on the surface 26 of the first outer layer 12 through the inner power layer 14, the inner ground layer 16 to the second outer layer 18 of the multilayered prior art printed wiring board 10. The first via 32 is conductively connected to the inner power layer 14. The first via 32 is not conductively connected to the inner ground layer 16 nor the second outer layer 18. The first via 32 is a through hole with regard to the inner ground layer 16 nor the second outer layer 18. Vias can selectively conductively connect or not connect to layers within a multilayered printed wiring board.

An electric current will flow from the inner power layer 14 vertically along the first via 32 through the printed wiring board 10 to the first via pad 30 and then laterally along the surface 26 of the first outer layer 12 along the trace 28 to the first pad 22 and to the surface mounted component 20.

Similarly, the second pad 24 is connected through a trace 34 to a second via pad 36 on the surface 26 of the first outer layer 12.

The second via 38 extends from the second via pad 36 on the surface 26 of the first outer layer 12 through the inner power layer 14, the inner ground layer 16 to the second outer layer 18 of the multilayered prior art printed wiring board 10. The second via 38 is conductively connected to the inner ground layer 16. The second via 38 is not conductively connected to the i nner p ower 1 ayer 14 n or the second outer layer 18. The second via 38 is a through hole with regard to the inner power layer 14 nor the second outer layer 18.

A signal will flow laterally from the surface mounted component 20 to the second pad 24 through the trace 34 to the second via pad 36 on the surface 26 of the first outer layer 12 and then vertically along the second via 38 to the inner ground layer 16.

Designs for printed wiring boards are demanding more and more electronic components, traces and vias on the same or smaller surface area. As circuits are designed to carry out more and more-complex functions, the number of electrical contact points for power supply and input-output signals to and from components continues to increase.

As the density of components increases and the spacing between components decreases, it becomes ever more difficult to connect the vias to underlying layers without shorting between adjacent electrical contacts.

Semiconductor components continue to be designed with more and more contact points. The multi-layer printed wiring boards to which these semiconductors are attached, therefore, require more associated pads and through-holes per unit area of printed wiring board than earlier designs.

It is difficult to route traces between finely-pitched (i.e., closely-spaced) components, pads and vias in a printed wiring board layer. It is likewise difficult to route traces between vias in an inner layer of a circuit board, or between vias and pads in a board outer layer, having pad-via combinations randomly oriented in all directions.

Known pad-via arrangements fall short of accommodating both the increased package contact point density and corresponding increase in the number of signals requiring routing from one layer of a circuit board to another layer.

The length of the traces and the fine pitch or high density of the traces between the components and the vias leading to inner ground and power layers causes excessive noise and ringing in the signals that the traces are carrying.

As the clock and data speeds of the surface mounted components increase, the trace lengths between the components represent a higher and higher part of the impedance between the surface mounted components and the inner ground layer or the inner power layer.

It is an object of this invention to provide an increased density of surface mounted components on a printed wiring board.

It is another object of this invention to decrease the impedance of the trace lengths between the surface mounted components and the inner ground layer or the inner power layer of a multilayered printed wiring board.

### SUMMARY OF THE INVENTION

According to the present invention, a surface mounted component and a via share the same pad on the surface of a multilayered printed wiring board to increase the density of surface mounted components on the surface and to reduce the impedance between the surface mounted component and the via.

Other objects and attainments together with a fuller understanding of the invention will become apparent and appreciated by referring to the following description and claims taken in conjunction with the accompanying drawings.

### BRIEF DESCRIPTION OF THE DRAWINGS

Figure 1 is a top view of a prior art printed wiring board with a trace connecting a surface mounted component to vias.

Figure 2 is a side view of the prior art printed wiring board of Figure 1.

Figure 3 is a top view of a printed wiring board with the surface mounted component and the vias sharing a common pad of the present invention.

Figure 4 is a side view of the printed wiring board of the present invention of Figure 3.

### DESCRIPTION OF THE INVENTION

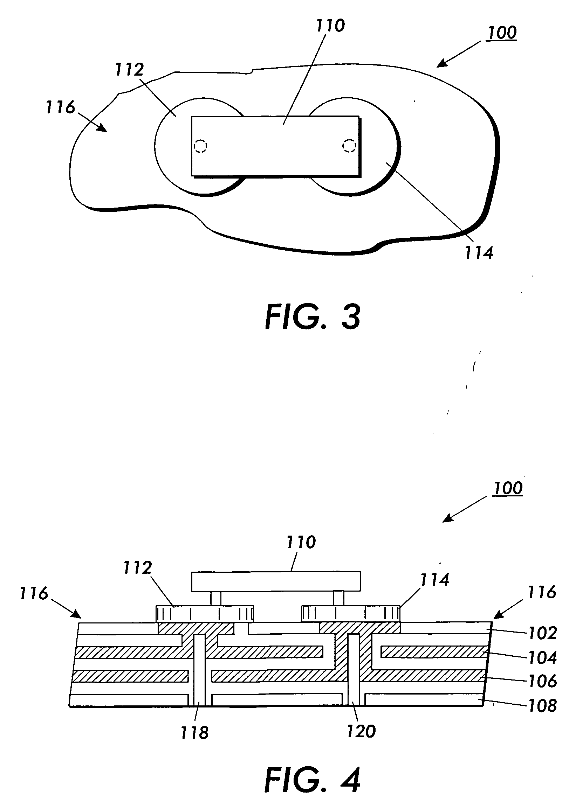

Reference is now made to Figures 3 and 4, wherein there is illustrated a printed wiring board 100 with the surface mounted component and the vias sharing a common pad in accordance with this invention.

As shown in Figure 4, the multilayered printed wiring board 100 has, in succession, a first outer layer 102, an inner power layer 104, an inner ground layer 106 and a second outer layer 108.

As shown in Figures 3 and 4, a surface mounted component 110 is mounted on a first pad 112 and a second pad 114 on the surface 116 of the first outer layer 102.

The first via 118 extends from the first pad 112 on the surface 116 of the first outer layer 102 through the inner power layer 104, the inner ground layer 106 to the second outer layer 108 of the multilayered printed wiring board 100. The first via 118 is conductively connected to the inner power layer 104. The first via 118 is not conductively connected to the inner ground layer 106 nor the second outer layer 108.

An electric current will flow from the inner power layer 104 vertically along the first via 118 through the printed wiring board 100 to the first pad 112 and then to the surface mounted component 110.

Similarly, the second via 120 extends from the second pad 114 on the surface 116 of the first outer layer 102 through the inner power layer 104, the inner ground layer 106 to the second outer layer 108 of the multilayered printed wiring board 100. The second via 120 is conductively connected to the inner ground layer 106. The second via 120 is not conductively connected to the inner power layer 104 nor the second outer layer 108.

A signal will flow vertically from the surface mounted component 110 to the second pad 114 on the surface 26 of the first outer layer 102 and then vertically along the second via 120 to the inner ground layer 106.

The multilayered printed wiring board 100 has no trace between the surface mounted component 110 and the vias 118 and 120. The surface mounted component 110 shares the same pad 112 with the first via 118 and the surface mounted component 110 shares the same pad 114 with the second via 120. There is no lateral flow of current or a signal along the surface 26 of the first outer layer 102.

The absence of a trace and a via pad increases the density on the printed wiring board for surface mounted components and any traces running from component to component.

The absence of a trace between surface mounted components and vias decreases the impedance of current flowing from the inner power level to the surface mounted component and vias decreases the impedance of the signal from the surface mounted component to the inner ground level.

The present invention of a surface mounted component and a via sharing the same pad is compatible with current day printed wiring board fabrication and assembly techniques. The present invention eliminates excessive etching used for the connectivity of surface mount component pads to traces to via pads.

## Claims

1. A printed wiring board comprising
a first outer layer;
a second outer layer;
at least one inner 1 ayer between said first outer layer and s aid s econd outer layer;
at least one via between said first outer layer and said at least one inner layer, said via having a pad on said first outer layer; and
at least one surface mounted component mounted on said first outer layer, said surface mounted component having the same pad as said via on said first outer layer.

2. The printed wiring board of claim 1 wherein said at least one inner layer further comprising a power layer and a ground layer.
